# DEMANDE DE BREVET EUROPEEN

(11) **EP 3 410 132 A1**
(43) Date de publication de la demande: **05.12.2018**
(21) Numéro de dépôt: 18174937.5
(22) Date de dépôt: 29.05.2018
(51) Int. Cl.: G01R 31/26

(54) **PROCÉDÉ DE DÉTERMINATION D'UNE TENSION DE SORTIE D'UN TRANSISTOR**

(30) Priorité: 31.05.2017 FR 1754805
(71) Demandeur: ALSTOM Transport Technologies, 93400 Saint-Ouen (FR)
(72) Inventeur: ESCROUZAILLES, Vincent, 65601 SEMEAC CEDEX (FR); PITON, Michel, 65601 SEMEAC CEDEX (FR)
(74) Mandataire: Lavoix

(57) **Abrégé**

L'invention concerne un procédé de détermination d'une tension de sortie d'un transistor (10), le transistor (10) comprenant une électrode d'entrée (G), une première électrode de sortie (C) et une deuxième électrode de sortie (E), le potentiel de la première électrode de sortie (C) étant plus élevé que le potentiel de la deuxième électrode de sortie (E), la tension de sortie étant la différence de potentiel entre la première électrode de sortie (C) et la deuxième électrode de sortie (E), le procédé comprenant :
- la mesure de l'évolution au cours du temps d'une tension de commande du transistor (10), la tension de commande étant la différence de potentiel entre l'électrode d'entrée (G) et la deuxième électrode de sortie (E), et
- la détermination de la tension de sortie à partir de la tension de commande mesurée.

## Description

La présente invention concerne un procédé de détermination d'une tension de sortie d'un transistor. La présente invention concerne aussi un dispositif de détermination associé. La présente invention concerne, également, un système de conversion d'énergie comprenant un tel dispositif de détermination et, avantageusement, une chaîne de traction ferroviaire comprenant un tel système de conversion d'énergie.

L'utilisation de transistors, notamment dans les chaînes de traction de véhicules ferroviaires, est connue. De tels transistors sont généralement utilisés en commutation, c'est-à-dire que lesdits transistors sont commandés de sorte à s'ouvrir et se fermer avec une fréquence définie.

De manière générale, un transistor comprend une électrode d'entrée, aussi appelée « base » ou « grille », une première électrode de sortie, aussi appelée « collecteur » ou « drain » et une deuxième électrode de sortie aussi appelée « émetteur » ou « source ».

Afin d'adapter la vitesse de commutation des transistors, et ainsi de minimiser les pertes dues à la commutation, il est connu de mesurer la tension de sortie entre la première et la deuxième électrode de sortie desdits transistors.

Cependant, la tension de sortie des transistors utilisés dans les chaînes de traction est souvent élevée. Par exemple, pour des transistors bipolaires à grille isolée, ladite tension peut valoir jusqu'à 4500 Volts. Une telle tension élevée est alors mesurée avec une chaîne de mesure adaptée.

Or, une chaîne de mesure adaptée implique de nombreux composants pour fonctionner, ce qui la rend complexe. En outre, une telle chaîne de mesure est contraignante à mettre en oeuvre pour chaque transistor.

Il existe donc un besoin pour un dispositif permettant de déterminer la tension de sortie d'un transistor qui soit de mise en oeuvre simplifiée.

A cet effet, l'invention a pour objet un procédé de détermination d'une tension de sortie d'un transistor, le transistor comprenant une électrode d'entrée, une première électrode de sortie et une deuxième électrode de sortie, le potentiel de la première électrode de sortie étant plus élevé que le potentiel de la deuxième électrode de sortie, la tension de sortie étant la différence de potentiel entre la première électrode de sortie et la deuxième électrode de sortie, le procédé comprenant une étape de mesure de l'évolution au cours du temps d'une tension de commande du transistor, la tension de commande étant la différence de potentiel entre l'électrode d'entrée et la deuxième électrode de sortie, et une étape de détermination au cours de laquelle la tension de sortie est déterminée à partir de la tension de commande mesurée.

Selon des modes de réalisation particuliers, le procédé comprenant une ou plusieurs des caractéristiques suivantes, prises isolément ou suivant toutes les combinaisons techniquement possibles :
- seule la tension de commande est mesurée au cours du procédé.
- le transistor comprend deux états : un premier état dans lequel le transistor est passant et un deuxième état dans lequel le transistor est non-passant, l'étape de mesure étant réalisée alors que le transistor est dans le deuxième état.
- le rapport en tension du transistor est supérieur ou égal à 50, le rapport en tension étant la valeur absolue de la tension de sortie du transistor par la tension de commande dudit transistor.
- le transistor est un transistor bipolaire ou unipolaire à grille isolée.
- le procédé comprend, en outre, les étapes de :
   - fourniture d'une première table d'étalonnage établie à partir d'un transistor d'étalonnage, le transistor d'étalonnage comprenant une électrode d'entrée, une première électrode de sortie et une deuxième électrode de sortie, le potentiel de la première électrode de sortie du transistor d'étalonnage étant plus élevé que le potentiel de la deuxième électrode de sortie dudit transistor d'étalonnage, la première table d'étalonnage représentant l'évolution de la tension de commande du transistor d'étalonnage en fonction du temps pour différentes tensions de sortie dudit transistor d'étalonnage et lorsqu'un courant de même premier profil prédéterminé est appliqué entre l'électrode d'entrée et la deuxième électrode de sortie dudit transistor d'étalonnage, la tension de commande du transistor d'étalonnage étant la différence de potentiel entre l'électrode d'entrée et la deuxième électrode de sortie du transistor d'étalonnage, la tension de sortie du transistor d'étalonnage étant la différence de potentiel entre la première électrode de sorti et la deuxième électrode de sortie du transistor d'étalonnage,
   - fourniture d'une deuxième table d'étalonnage représentant l'évolution de la tension de sortie du transistor d'étalonnage en fonction de la durée mise par la tension de commande dudit transistor d'étalonnage pour atteindre une valeur seuil de tension prédéterminée à partir de l'instant où le courant ayant le premier profil prédéterminé est appliqué entre l'électrode d'entrée et la deuxième électrode de sortie du transistor d'étalonnage,
   - application d'un courant ayant le premier profil prédéterminé entre l'électrode d'entrée et la deuxième électrode de sortie du transistor, l'étape de mesure étant réalisée simultanément à l'étape d'application, l'étape de détermination comprenant la détermination, à partir de la première table d'étalonnage et de la tension de commande mesurée du transistor, de la durée mise par la tension de commande du transistor pour atteindre la valeur seuil de tension prédéterminée, l'étape de détermination comprenant, en outre, la détermination, à partir de la durée déterminée et de la deuxième table d'étalonnage, de la tension de sortie du transistor.
- le transistor comprend deux états : un premier état dans lequel le transistor est passant et un deuxième état dans lequel le transistor est non-passant, le procédé comprenant une étape de mise du transistor dans le deuxième état, avec une consigne déterminée en fonction de la tension de sortie déterminée dudit transistor.
- le procédé comprend une étape de fourniture d'une troisième table d'étalonnage, la troisième table d'étalonnage associant un deuxième profil de courant de commande pour chaque valeur de tension de sortie du transistor d'étalonnage, l'étape de mise dans le deuxième état comprenant, en outre, la sélection de l'un des deuxièmes profil de courant de commande en fonction de la tension de sortie déterminée du transistor et de la troisième table d'étalonnage, et d'application, d'un courant de commande ayant le deuxième profil sélectionné entre l'électrode d'entrée et la deuxième électrode de sortie du transistor, le deuxième profil de courant sélectionné étant propre à mettre le transistor dans le deuxième état.

L'invention concerne aussi un dispositif de détermination d'une tension de sortie d'un transistor, le transistor comprenant une électrode d'entrée, une première électrode de sortie et une deuxième électrode de sortie, le potentiel de la première électrode de sortie étant plus élevé que le potentiel de la deuxième électrode de sortie, la tension de sortie étant la différence de potentiel entre la première électrode de sortie et la deuxième électrode de sortie, le dispositif comprenant une unité de mesure de l'évolution au cours du temps d'une tension de commande du transistor, la tension de commande étant la différence de potentiel entre l'électrode d'entrée et la deuxième électrode de sortie, et une unité de traitement propre à déterminer la tension de sortie à partir de la tension de commande mesurée.

L'invention concerne également un système de conversion d'énergie comprenant au moins un transistor et un dispositif tel que décrit précédemment associé audit transistor.

D'autres caractéristiques et avantages de l'invention apparaitront à la lecture de la description qui va suivre de modes de réalisation de l'invention, donnée à titre d'exemple uniquement et en référence aux dessins qui sont :
- figure 1, une représentation schématique d'un véhicule ferroviaire comprenant une chaîne de traction comportant un système de conversion d'énergie, le système de conversion comprenant un transistor et un dispositif de détermination selon l'invention,
- figure 2, une représentation schématique d'un transistor et d'un dispositif de détermination de la tension de sortie dudit transistor,
- figure 3, une représentation schématique d'une première table d'étalonnage,
- figure 4, une représentation schématique d'un premier profil de courant de commande et de la tension de commande du transistor en résultant,
- figure 5, une représentation schématique d'une deuxième table d'étalonnage, et
- figure 6, une représentation schématique d'un deuxième profil de courant de commande et de la tension de commande du transistor en résultant.

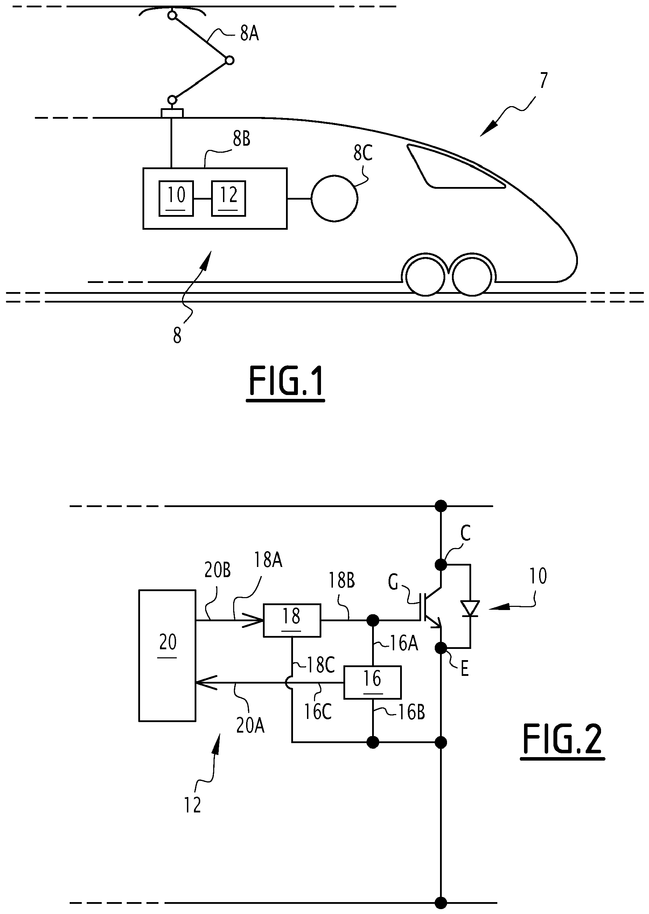

Un véhicule ferroviaire 7 est illustré sur la figure 1. Le véhicule ferroviaire 7 est, par exemple, un train ou un tramway.

Le véhicule ferroviaire 7 comprend une chaîne de traction 8. Dans l'exemple illustré sur la figure 1, la chaîne de traction 8 comprend un pantographe 8A, un système de conversion d'énergie 8B et un moteur 8C.

Le système de conversion 8B comprend au moins un transistor 10 et un dispositif de détermination 12 qui sont illustrés plus en détails sur la figure 2.

Comme illustré sur la figure 2, le transistor 10 comprend une électrode d'entrée G, une première électrode de sortie C et une deuxième électrode de sortie E. Le potentiel de la première électrode de sortie C est plus élevé que le potentiel de la deuxième électrode de sortie E du transistor 10.

Le transistor 10 comprend une tension de sortie V_{CE} définie comme étant la différence de potentiel entre la première électrode de sortie C et la deuxième électrode de sortie E. Le transistor 10 comprend aussi une tension de commande V_{GE} définie comme étant la différence de potentiel entre l'électrode d'entrée G et la deuxième électrode de sortie E.

Le transistor 10 est, par exemple, un transistor bipolaire, tel qu'un transistor bipolaire à grille isolée (abrégé en anglais par *IGBT*). En variante, le transistor 10 est un transistor unipolaire à grille isolée.

Lorsque le transistor 10 est un transistor bipolaire ou unipolaire à grille isolée, l'électrode d'entrée G correspond à la base du transistor 10, la première électrode de sortie C correspond au collecteur du transistor 10 et la deuxième électrode de sortie E correspond à l'émetteur du transistor 10.

Dans une variante, le transistor 10 est un transistor à effet de champ à grille isolée (abrégé en anglais par *MOSFET*).

Lorsque le transistor 10 est un transistor MOSFET, l'électrode d'entrée G correspond à la grille du transistor 10, la première électrode de sortie C correspond au drain du transistor 10 et la deuxième électrode de sortie E correspond à la source du transistor 10.

Avantageusement, le rapport en tension du transistor 10 est supérieur ou égal à 50. Le rapport en tension du transistor 10 est défini comme étant la valeur absolue du rapport entre la tension de sortie V_{CE} du transistor 10 et la tension de commande V_{GE} dudit transistor 10.

Plus particulièrement, la tension de sortie V_{CE} du transistor 10 est, par exemple, supérieure ou égale à 1000 Volts et la tension de commande V_{GE} du transistor 10 est, par exemple, comprise entre -15 Volts et +15 Volts.

Le transistor 10 comprend deux états : un premier état dans lequel le transistor 10 est passant et un deuxième état dans lequel le transistor 10 est non-passant. Il est entendu par le terme « passant », le fait que le transistor 10 se comporte comme un matériau conducteur. Il est entendu par le terme « non-passant », le fait que le transistor 10 se comporte comme un matériau non-conducteur.

Le transistor 10 est propre à passer du deuxième état vers le premier état lorsqu'une tension de seuil est atteinte entre l'électrode d'entrée G et la deuxième électrode de sortie E. La tension de seuil est, par exemple, supérieure ou égale à 5 Volts.

Dans la suite de la description, le transistor 10 est un transistor à caractériser, c'est-à-dire un transistor dont on souhaite déterminer la tension de sortie V_{CE}.

Le dispositif de détermination 12 est propre à mettre en oeuvre un procédé de détermination de la tension de sortie V_{CE} du transistor 10 qui sera décrit plus en détails dans la suite de la description.

Le dispositif 12 comprend une unité de mesure 16, un injecteur de courant 18 et une unité de traitement de données 20.

L'unité de mesure 16 est propre à mesurer la tension de commande V_{GE} du transistor 10.

Dans l'exemple illustré sur la figure 2, l'unité de mesure 16 comprend deux bornes d'entrée 16A, 16B et une borne de sortie 16C. La première borne d'entrée 16A est reliée à l'électrode d'entrée G du transistor 10. La deuxième borne d'entrée 16B est reliée à la deuxième électrode E du transistor 10. La borne de sortie 16C est reliée à l'unité de traitement 20 comme cela sera décrit dans ce qui suit.

L'unité de mesure 16 est, par exemple, un voltmètre.

L'injecteur de courant 18 est propre à injecter un courant entre l'électrode d'entrée G et la deuxième électrode de sortie E du transistor 10.

Dans l'exemple illustré sur la figure 2, l'injecteur de courant 18 comprend une borne d'entrée 18A et deux bornes de sortie 18B, 18C. La borne d'entrée 18A est reliée à l'unité de traitement 20 comme cela sera décrit dans ce qui suit. La première borne de sortie 18B est reliée à l'électrode d'entrée G du transistor 10. La deuxième borne de sortie 18C est reliée à la deuxième électrode E du transistor 10.

L'injecteur de courant 18 est, de préférence, une source de courant. Il est entendu par le terme « source de courant », un dispositif en un seul bloc propre à produire un courant électrique constant.

En variante, l'injecteur de courant 18 est un dispositif en plusieurs blocs comprenant, par exemple, un pont de résistances relié à une source de tension.

L'unité de traitement 20 est propre à déterminer la tension de sortie V_{CE} du transistor 10. L'unité de traitement 20 est, également, propre à commander l'injection d'un courant par l'injecteur de courant 18.

Dans l'exemple illustré sur la figure 2, l'unité de traitement 20 comprend une borne d'entrée 20A et une borne de sortie 20B. La borne d'entrée 20A est reliée à la borne de sortie 16C de l'unité de mesure 16. La borne de sortie 20B est reliée à la borne d'entrée 18A de l'injecteur de courant 18.

L'unité de traitement 20 comprend, de préférence, une mémoire et un processeur.

L'unité de traitement 20 est, par exemple, un circuit logique programmable tel qu'un FPGA (de l'anglais *Field-Programmable Gate Array* traduit en français par *Réseau de Portes Programmables*).

Un procédé de détermination de la tension de sortie V_{CE} du transistor 10, à partir du dispositif de détermination 12, va maintenant être décrit.

Le procédé de détermination comprend une étape 100 de fourniture d'une première table d'étalonnage établie à partir d'un transistor d'étalonnage.

Le transistor d'étalonnage comprend une électrode d'entrée, une première électrode de sortie et une deuxième électrode de sortie. Le potentiel de la première électrode de sortie du transistor d'étalonnage est plus élevé que le potentiel de la deuxième électrode de sortie dudit transistor d'étalonnage.

La première table d'étalonnage est susceptible d'être présentée sous différentes formes. Par exemple, la première table d'étalonnage est un graphique ou un tableau.

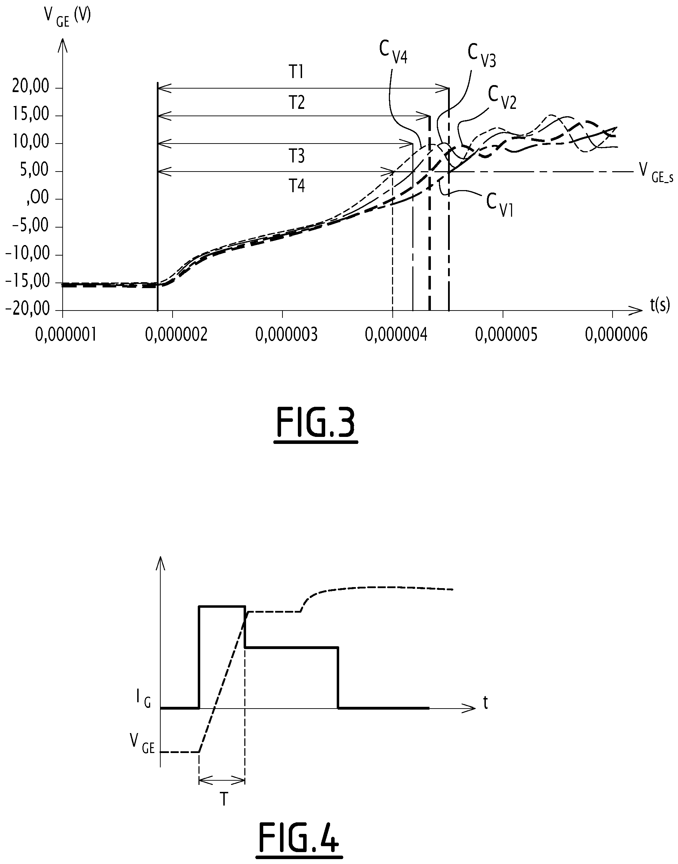

Un exemple de première table d'étalonnage est illustré sur la figure 3. La première table d'étalonnage illustrée sur la figure 3 comprend des courbes. Chaque courbe représente l'évolution de la tension de commande V_{GE} du transistor d'étalonnage 10 en fonction du temps pour une tension de sortie V_{CE} donnée dudit transistor d'étalonnage. En particulier, chacune des courbes C_{V1}, C_{V2}, C_{V3}, C_{V4} de la figure 3 a été obtenue pour une tension de sortie V_{CE} du transistor d'étalonnage égale à, respectivement, 1000 Volts, 2500 Volts, 3600 Volts et 4500 Volts.

En outre, chaque courbe de la figure 3 a été établie simultanément à l'application d'un courant de commande ayant un premier profil prédéterminé entre l'électrode d'entrée et la deuxième électrode de sortie dudit transistor d'étalonnage.

Le premier profil correspond à la mise à l'état passant du transistor.

Le courant de commande ayant le premier profil est choisi de sorte que la tension de commande V_{GE} du transistor d'étalonnage augmente rapidement de sorte à faciliter la mesure de la tension de commande V_{GE}, et donc l'obtention de la première courbe d'étalonnage. Par exemple, comme illustré sur la figure 3, le premier profil est choisi de sorte que la tension de commande V_{GE} du transistor d'étalonnage, qui part de -15 Volts, atteigne des valeurs pouvant aller jusqu'à +15 Volts.

Un exemple du premier profil est illustré sur la figure 4. Comme visible sur cette figure 4, le premier profil présente différents paliers. Chaque palier correspond à une valeur constante du courant. Le palier de valeur la plus élevée est le premier palier, c'est-à-dire le palier appliqué au début de l'injection du courant.

De préférence, la valeur du courant selon le premier profil au niveau du palier le plus élevé est supérieure ou égale à 200 milliampères.

Le procédé comprend aussi une étape 110 de fourniture d'une deuxième table d'étalonnage.

La deuxième table d'étalonnage est susceptible d'être présentée sous différentes formes. Par exemple, la deuxième table d'étalonnage est un graphique ou un tableau.

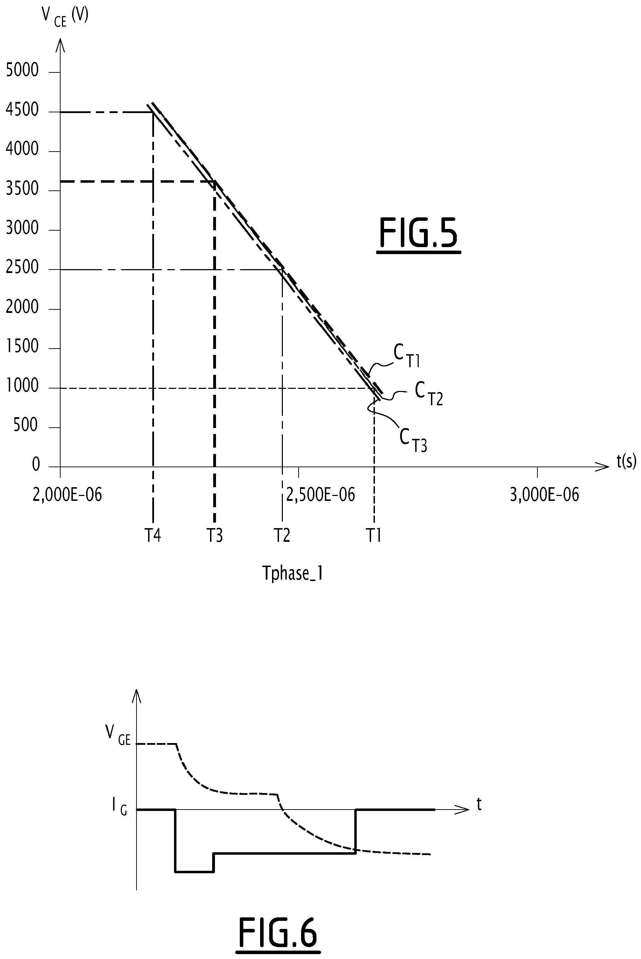

Un exemple de deuxième table d'étalonnage est illustré sur la figure 5. La deuxième table d'étalonnage de la figure 5 représente l'évolution de la tension de sortie V_{CE} du transistor d'étalonnage en fonction d'une durée T. La durée T est la durée mise par la tension de commande V_{GE} du transistor d'étalonnage pour atteindre une valeur seuil de tension prédéterminée V_{GE_S} à partir de l'instant où le courant ayant le premier profil est appliqué entre l'électrode d'entrée et la deuxième électrode de sortie dudit transistor d'étalonnage.

La valeur seuil de tension prédéterminée V_{GE_S} est, par exemple, choisie expérimentalement. Pour les première et deuxième tables d'étalonnage illustrées en figures 3 et 5, la valeur seuil de tension prédéterminée V_{GE_S} est fixée à 5 Volts.

Dans le mode de réalisation illustré sur les figures 3 et 5, la deuxième table d'étalonnage de la figure 5 est obtenue à partir de la première table d'étalonnage de la figure 3. En effet, la première table d'étalonnage permet d'obtenir les durées T, chacune associée à une tension de sortie V_{CE}. Selon un exemple, les durées T1, T2, T3, T4 obtenues respectivement pour chacune des courbes C_{V1}, C_{V2}, C_{V3}, C_{V4} sont illustrées schématiquement sur la figure 3.

La deuxième table d'étalonnage de la figure 5 comprend trois courbes C_{T1}, C_{T2}, C_{T3} chacune obtenue pour une température égale à, respectivement, 25 degrés Celsius (°C), 80 °C et 125 °C.

A partir de ces trois courbes C_{T1}, C_{T2}, C_{T3} il est observé une relation linéaire entre la tension de sortie V_{CE} du transistor d'étalonnage et la durée T. Ainsi, connaissant la durée T, la deuxième courbe d'étalonnage permet de remonter directement à la tension de sortie V_{CE}.

En outre, les trois courbes C_{T1}, C_{T2}, C_{T3} étant superposées, cela permet d'en déduire que la relation entre la tension de sortie V_{CE} et la durée T est indépendante de la température du transistor d'intérêt.

Le procédé comprend, également, une étape 120 de fourniture d'une troisième table d'étalonnage.

La troisième table d'étalonnage est susceptible d'être présentée sous différentes formes. Par exemple, la troisième table d'étalonnage est un tableau.

La troisième table d'étalonnage associe un deuxième profil de courant de commande respectif pour chaque valeur de la tension de sortie V_{CE} du transistor d'étalonnage.

Le procédé comprend, également, une étape 130 d'application, par l'injecteur de courant 18, d'un courant ayant le premier profil prédéterminé entre l'électrode d'entrée G et la deuxième électrode de sortie E du transistor 10 de sorte à faire passer le transistor 10 dans le premier état.

En parallèle, le procédé comprend une étape 140 de mesure, par l'unité de mesure 16, de l'évolution au cours du temps de la tension de commande V_{GE} du transistor 10. Les mesures sont alors communiquées par l'unité de mesure 16 à l'unité de traitement 20.

L'étape de mesure 140 est mise en oeuvre ou réalisée avant la mise en conduction du transistor 10, c'est-à-dire avant que la tension appliquée soit supérieure ou égale à la tension de seuil définie précédemment.

Il est entendu par le terme « mesurer », le fait d'obtenir une valeur directement par un instrument de mesure, tel qu'un voltmètre. Il est entendu par le terme « déterminer », le fait de déduire une valeur, par exemple, par calcul ou au moyen de tables d'étalonnage, mais non pas directement au moyen d'un instrument de mesure.

Le procédé comprend, ensuite, une étape 150 de détermination au cours de laquelle la tension de sortie V_{CE} du transistor 10 est déterminée à partir de la tension de commande V_{GE} mesurée.

Selon un mode de réalisation particulier, l'étape de détermination 150 comprend la détermination, à partir de la première table d'étalonnage et de la tension de commande V_{GE} mesurée, de la durée T mise par la tension de commande V_{GE} dudit transistor 10 pour atteindre la valeur seuil de tension prédéterminée V_{GE_S}. En pratique, connaissant la tension de commande V_{GE} du transistor 10, la première table d'étalonnage de la figure 3, permet de remonter directement à la durée T recherchée.

L'étape de détermination 150 comprend, ensuite, la détermination, à partir de la durée T déterminée et de la deuxième table d'étalonnage, de la tension de sortie V_{CE} du transistor 10. En pratique, la deuxième table d'étalonnage illustrée en figure 5, permet de remonter directement, connaissant la durée T déterminée, à la tension de sortie V_{CE} du transistor 10.

Selon un mode de réalisation particulier, le procédé comprend, également, une étape 160 de mise hors conduction du transistor 10, c'est-à-dire de mise à l'état non passant du transistor 10, avec une consigne déterminée en fonction de la tension de sortie V_{CE} déterminée. Cela permet d'adapter la vitesse de commutation du transistor 10 en fonction de la tension de sortie V_{CE} déterminée.

Plus précisément, l'étape de mise hors conduction 160 comprend la sélection, en fonction de la tension de sortie V_{CE} déterminée et de la troisième table d'étalonnage, du deuxième profil de courant de commande à appliquer entre l'électrode d'entrée G et la deuxième électrode de sortie E du transistor 10.

Un exemple de deuxième profil de courant de commande est illustré sur la figure 6. Comme visible sur cette figure 6, le deuxième profil de courant de commande présente différents paliers. Chaque palier correspond à une valeur constante du courant. Le palier de valeur la plus basse est le premier palier, c'est-à-dire le palier appliqué au début de l'injection du courant. Un tel deuxième profil de courant de commande permet d'amener la tension de commande V_{GE} du transistor 10 le plus vite possible à une tension de basculement. Ensuite, les paliers ont des valeurs légèrement plus élevées, ce qui permet de limiter les remontées de tension et donc d'éviter de détériorer le transistor 10.

L'étape de mise hors conduction 160 comprend, ensuite, l'application, d'une consigne sous la forme d'un courant ayant le deuxième profil déterminé entre l'électrode d'entrée G et la deuxième électrode de sortie E du transistor 10. Le transistor 10 est alors mis hors conduction.

Ainsi, le procédé de détermination permet de déterminer avec une chaîne de mesure simple et basse tension, tel qu'un voltmètre, la tension de sortie V_{CE} haute tension d'un transistor 10.

La tension de commande V_{GE} du transistor 10 étant faible par rapport à la tension de sortie V_{CE} dudit transistor 10, la mesure de tension est rapide et simple par rapport à une mesure avec une chaîne de mesure dédiée à des fortes tensions. En effet, dans le présent procédé de détermination, seule une mesure de la tension de commande du transistor 10 est effectuée et aucune autre mesure n'est ensuite effectuée.

Le dispositif de détermination est, en outre, plus compact et plus simple d'utilisation. Il est adaptable à tous les transistors d'un système de conversion d'énergie par exemple.

En outre, le dispositif de détermination 12 est simple puisque ledit dispositif 12 comprend seulement une unité de mesure 16, un injecteur de courant 18 et une unité de traitement 20. Le nombre de composants impliqués pour obtenir la tension de sortie V_{CE} du transistor 10 est donc réduit par rapport à une chaîne de mesure de l'état de la technique dédiée aux hautes tensions.

L'utilisation d'un injecteur de courant 18 sous la forme d'une source de courant permet d'imposer un courant constant durant la phase de mesure de la tension de commande V_{GE} du transistor 10. Cela permet de limiter les variations de courant, et ainsi de rendre linéaire la relation entre la tension de sortie Vce et la durée T mise par la tension de commande V_{GE} du transistor 10 pour atteindre la valeur seuil de tension prédéterminée V_{GE_S}.

Ainsi, la mesure de tension est très simple à mettre en oeuvre contrairement aux solutions de l'état de la technique qui intègrent une chaîne de mesure directe de la tension de sortie V_{CE} qui est relativement complète et complexe.

La tension de sortie V_{CE} ainsi déterminée peut alors être utilisée pour diminuer les pertes en commutation et commuter le transistor 10 avec des paramètres qui réduiront les pertes de commutation comme décrit lors de l'étape 160 de mise hors conduction.

En variante, la tension de sortie V_{CE} du transistor 10 pourrait être utilisée pour des applications variées, notamment pour contrôler la défaillance du transistor 10 ou encore dans des applications dans lesquelles le transistor 10 serait utilisé pour des capteurs.

Dans la présente demande, l'homme du métier comprendra que les termes « propre à » et « configuré pour » sont synonymes.

## Revendications

1. Procédé de détermination d'une tension de sortie (V_{CE}) d'un transistor (10), le transistor (10) comprenant une électrode d'entrée (G), une première électrode de sortie (C) et une deuxième électrode de sortie (E), le potentiel de la première électrode de sortie (C) étant plus élevé que le potentiel de la deuxième électrode de sortie (E), la tension de sortie (V_{CE}) étant la différence de potentiel entre la première électrode de sortie (C) et la deuxième électrode de sortie (E), le procédé comprenant :
- une étape de mesure de l'évolution au cours du temps d'une tension de commande (V_{GE}) du transistor (10), la tension de commande (V_{GE}) étant la différence de potentiel entre l'électrode d'entrée (G) et la deuxième électrode de sortie (E), et
- une étape de détermination au cours de laquelle la tension de sortie (V_{CE}) est déterminée à partir de la tension de commande (V_{GE}) mesurée.

2. Procédé selon la revendication 1, dans lequel seule la tension de commande (V_{GE}) est mesurée au cours du procédé.

3. Procédé selon la revendication 1 ou 2, dans lequel le transistor (10) comprend deux états : un premier état dans lequel le transistor (10) est passant et un deuxième état dans lequel le transistor (10) est non-passant, l'étape de mesure étant réalisée alors que le transistor (10) est dans le deuxième état.

4. Procédé selon l'une quelconque des revendications 1 à 3, dans lequel le rapport en tension du transistor (10) est supérieur ou égal à 50, le rapport en tension étant la valeur absolue de la tension de sortie (V_{CE}) du transistor (10) par la tension de commande (V_{GE}) dudit transistor (10).

5. Procédé selon l'une quelconque des revendications 1 à 4, dans lequel le transistor (10) est un transistor bipolaire ou unipolaire à grille isolée.

6. Procédé selon l'une quelconque des revendications 1 à 5, dans lequel le procédé comprend, en outre, les étapes de :
- fourniture d'une première table d'étalonnage établie à partir d'un transistor d'étalonnage, le transistor d'étalonnage comprenant une électrode d'entrée, une première électrode de sortie et une deuxième électrode de sortie, le potentiel de la première électrode de sortie du transistor d'étalonnage étant plus élevé que le potentiel de la deuxième électrode de sortie dudit transistor d'étalonnage, la première table d'étalonnage représentant l'évolution de la tension de commande (V_{GE}) du transistor d'étalonnage en fonction du temps pour différentes tensions de sortie (V_{CE}) dudit transistor d'étalonnage et lorsqu'un courant de même premier profil prédéterminé est appliqué entre l'électrode d'entrée et la deuxième électrode de sortie dudit transistor d'étalonnage, la tension de commande (V_{GE}) du transistor d'étalonnage étant la différence de potentiel entre l'électrode d'entrée (G) et la deuxième électrode de sortie (E) du transistor d'étalonnage, la tension de sortie (V_{CE}) du transistor d'étalonnage étant la différence de potentiel entre la première électrode de sortie (C) et la deuxième électrode de sortie (E) du transistor d'étalonnage,
- fourniture d'une deuxième table d'étalonnage représentant l'évolution de la tension de sortie (V_{CE}) du transistor d'étalonnage en fonction de la durée (T) mise par la tension de commande (V_{GE}) dudit transistor d'étalonnage pour atteindre une valeur seuil de tension prédéterminée (V_{GE_S}) à partir de l'instant où le courant ayant le premier profil prédéterminé est appliqué entre l'électrode d'entrée et la deuxième électrode de sortie du transistor d'étalonnage,
- application d'un courant ayant le premier profil prédéterminé entre l'électrode d'entrée (G) et la deuxième électrode de sortie (E) du transistor (10),
l'étape de mesure étant réalisée simultanément à l'étape d'application,
l'étape de détermination comprenant la détermination, à partir de la première table d'étalonnage et de la tension de commande (V_{GE}) mesurée du transistor (10), de la durée (T) mise par la tension de commande (V_{GE}) du transistor (10) pour atteindre la valeur seuil de tension prédéterminée (V_{GE_S}),
l'étape de détermination comprenant, en outre, la détermination, à partir de la durée (T) déterminée et de la deuxième table d'étalonnage, de la tension de sortie (V_{CE}) du transistor (10).

7. Procédé selon l'une quelconque des revendications 1 à 6, dans lequel le transistor (10) comprend deux états : un premier état dans lequel le transistor (10) est passant et un deuxième état dans lequel le transistor (10) est non-passant, le procédé comprenant une étape de mise du transistor (10) dans le deuxième état, avec une consigne déterminée en fonction de la tension de sortie (V_{CE}) déterminée dudit transistor (10).

8. Procédé selon la revendication 7, dans lequel le procédé comprend une étape de fourniture d'une troisième table d'étalonnage, la troisième table d'étalonnage associant un deuxième profil de courant de commande pour chaque valeur de tension de sortie (V_{CE}) du transistor d'étalonnage, l'étape de mise dans le deuxième état comprenant, en outre, la sélection de l'un des deuxièmes profil de courant de commande en fonction de la tension de sortie (V_{CE}) déterminée du transistor (10) et de la troisième table d'étalonnage, et d'application, d'un courant de commande ayant le deuxième profil sélectionné entre l'électrode d'entrée (G) et la deuxième électrode de sortie (E) du transistor (10), le deuxième profil de courant sélectionné étant propre à mettre le transistor (10) dans le deuxième état.

9. Dispositif (12) de détermination d'une tension de sortie (V_{CE}) d'un transistor (10) le transistor (10) comprenant une électrode d'entrée (G), une première électrode de sortie (C) et une deuxième électrode de sortie (E), le potentiel de la première électrode de sortie (C) étant plus élevé que le potentiel de la deuxième électrode de sortie (E), la tension de sortie (V_{CE}) étant la différence de potentiel entre la première électrode de sortie (C) et la deuxième électrode de sortie (E), le dispositif (12) comprenant :
- une unité de mesure (16) de l'évolution au cours du temps d'une tension de commande (V_{GE}) du transistor (10), la tension de commande (V_{GE}) étant la différence de potentiel entre l'électrode d'entrée (G) et la deuxième électrode de sortie (E), et
- une unité de traitement (20) propre à déterminer la tension de sortie (V_{CE}) à partir de la tension de commande (V_{GE}) mesurée.

10. Système de conversion d'énergie (8B) comprenant au moins un transistor (10) et un dispositif (12) selon la revendication 9 associé audit transistor (10).
